# EUROPEAN PATENT SPECIFICATION

(11) **EP 4 231 023 B1**
(45) Date of publication and mention of the grant of the patent: **06.11.2024**
(21) Application number: 22382128.1
(22) Date of filing: 17.02.2022
(51) Int. Cl.: G01R 1/20

(54) **CURRENT SENSOR FOR MOTOR VEHICLES, POWER SUPPLY SYSTEM COMPRISING THE CURRENT SENSOR AND ASSEMBLY METHOD OF THE CURRENT SENSOR**
STROMSENSOR FÜR KRAFTFAHRZEUGE, STROMVERSORGUNGSSYSTEM, DAS DEN STROMSENSOR UMFASST, UND MONTAGEVERFAHREN DES STROMSENSORS
CAPTEUR DE COURANT DESTINÉ À DES VÉHICULES À MOTEUR, SYSTÈME D'ALIMENTATION EN ÉNERGIE COMPRENANT LE CAPTEUR DE COURANT ET PROCÉDÉ D'ASSEMBLAGE DU CAPTEUR DE COURANT

(43) Date of publication of application: 23.08.2023
(73) Proprietor: Fico Triad, S.A., 08028 Barcelona (ES)
(72) Inventor: Navarro Henares, Alexandre, 08232 Viladecavalls (ES)
(74) Representative: Elzaburu S.L.P.

(56) References cited:
- EP-B1- 2 085 785
- DE-A1- 102008 006 183
- DE-A1- 102018 200 621
- US-A1- 2008 050 985
- US-A1- 2016 146 900
- US-A1- 2020 025 802
- US-A1- 2020 182 914

## Description

### Field of the invention

The present invention relates to a current sensor for vehicles, a power supply system comprising said current sensor and to the assembly method of said current sensor.

### Background of the invention

A power supply system comprises a current sensor for measuring the electric current. In particular, a power supply system may include an electrical conductor, for instance, a busbar or an electric cable, electrically connected to a shunt device of the current sensor.

The current sensor detects the current flowing through a circuit. A controller would take this value and adapt the circuit accordingly to avoid overcurrent or lack of current to parts of the circuit.

A current sensor can be applied to any circuit through which current passes. For instance, an electric or hybrid vehicle comprises a power supply system which, in turn, comprises a current sensor and an energy accumulator, e.g., a battery.

The amperage that is usually used in an electric vehicle is higher than 50 amperes (A), for example, from 100 A to 1000 A. There is a risk that the current sensor does not accurately detect the current flowing which may result in a safety risk.

Typically, the current sensor employs a very small electrical resistance known as a "shunt" or "shunt device" or "shunt resistor".

In electronics, a shunt is a resistive load through which an electric current flows. Generally, the resistance of a shunt is known precisely and is used to determine the intensity of the electric current flowing through the resistance by measuring the voltage difference across it, using Ohm's law (I = V/R).

Therefore, a conventional shunt device generally comprises a first portion comprising a resistive element having a pre-set resistance and a second portion connected to an electrical conductor.

In an embodiment, the shunt device may comprise a first portion, for instance a middle portion, wherein the resistive element is located that may be made of manganese (Mn), and two second portions, for instance end portions, wherein the electrical conductors are attached. These end portions or second portions may be made of copper (Cu) or a copper alloy. When a current flows through the shunt device, a voltage drop occurs in the resistive element and a current value may be calculated according to Ohm's law by measuring a voltage difference in this case. Furthermore, the conventional shunt device comprises electrical connection means between the shunt and, for instance, a printed circuit board. The electrical connection means may be connection pins or pads that are configured to transfer the measured voltage to the printed circuit board (PCB). The pins are soldered to the printed circuit board (PCB), and a current value is calculated by applying Ohm's law.

However, in a conventional shunt device, the electrical connection means, for instance a pin, is vulnerable to vibration or impact generated when a vehicle runs and/or when the conventional shunt resistor is being mounted on the current sensor, and thus the joint, the pin or an element in contact with the pin can easily break. In many cases, the broken element serves as a major cause of breakage of the current sensor. An objective to be solved by the invention is thus to reduce the likelihood of breakage of the electrical connection means.

Conventional shunt devices comprise two holes, each in one end portion and both located outside a housing that encloses the printed circuit board and the middle portion of the shunt device. When the factory operator, or automated robot, runs a screw through each hole to attach the current sensor to the conductors of the power supply system, a problem that currently exists is that since the hole is close to the mentioned housing, the screwdriving tool unfortunately tends to touch the housing which makes the screwing operation more difficult for the operator.

In addition, when the electrical conductors are screwed to the current sensor, if the holes of the end portions are away from the housing to prevent the housing from interfering with the screwing operation as explained before, said operation causes a torque which may lead to breakage of the electrical connection means or of the elements in contact with them.

It is known document US2008050985A1 disclosing a connector suitable for establishing an electrical connection with any number of batteries. The connector includes any number of features for assessing operating characteristics associated with the battery, such as but not limited to current, voltage, and temperature. The connector optionally being of a robust design and configured to ameliorate vibrations and sustain hammer tests.

It is known document DE102008006183A1 disclosing a device for measuring current for checking the functionality of a battery in motor vehicles.

It is known document EP2085785A2 disclosing a device for measuring electricity.

It is known document US2016146900A1 disclosing a battery sensor assembly for a vehicle.

It is known document DE102018200621 A1 disclosing a measuring arrangement.

It is known document US2020025802A1 disclosing shunt resistor including first and second terminals made of an electrically conductive metal material, and a resistive element disposed between the first terminal and the second terminal.

It is known document US2020182914A1 disclosing a current measuring device for measuring current.

### Summary of the invention

The present invention has the aim of avoiding breakage of the electrical connection means, for instance, the pins, when mounting the current sensor to the power supply system. In addition, the claimed current sensor facilitates the assembly process of the shunt device.

The current sensor for motor vehicles object of the invention is defined in claim 1.

As previously explained, the shunt device further comprises electrical connection means in electrical contact with the printed circuit board.

In an embodiment the shunt device and the housing may be further attached to a battery pack. For instance, the attaching means being fastening means, more specifically a screw that may attach the shunt device, the housing and the battery pack.

Preferably, the attaching means is configured to electrically connect the electrical conductor and the shunt device. For example, the attaching means is adapted for attaching the electrical conductor and the shunt device to each other.

Electrical conductor is any element that transports electrical energy from one end to another. For instance, a busbar or a wire and it may include any attaching means for improving the connection of the electrical conductor with the current sensor, such as, tubular lugs.

Preferably, the mentioned first and second hole are aligned with each other, i.e., they are concentric.

Preferably, the housing comprises a first part, i.e., support base, and a second part, i.e., cover. In use, the second part does not cover the first hole of the shunt device so that the attaching means is not covered by said second part.

Preferably, the housing further comprises an element in connection, i.e., physically linked, with the shunt device so as to prevent the rotation of the shunt device with respect to the housing when the attaching means is being inserted through the first and the second hole for attaching the shunt device to the housing.

The housing is adapted to receive at least a portion of the printed circuit board (PCB) and a portion of the shunt device and, according to the above technical features, the hole of the shunt device is located on the inside of the housing, i.e., within the perimeter or contour of the housing, to match the hole located in the housing.

Therefore, the current sensor comprises:
- a printed circuit board (PCB),
- a shunt device comprising electrical connection means that are in electrical contact with the printed circuit board (PCB),
- a housing enclosing, i.e., surrounding within its perimeter, at least a portion of the printed circuit board and at least a portion of the shunt device, and
- attaching means between the shunt device and the housing, for instance, fastening means, in a specific embodiment a screw,
- the shunt device comprising a first hole and the housing comprising a second hole that are located opposite each other. The attaching means goes through the first and through the second hole so as to attach the shunt device to the housing. For instance, a screw or a bolt goes through the first and the second hole to at least attach the shunt to the housing.

According to the above mentioned, the second hole in the housing may be a through hole or a blind hole. For instance, in an embodiment in which the shunt device and the housing are further attached to a battery pack, the second hole would be a through hole and the attaching means would extend into the battery pack.

The second hole in the housing may be threaded. It can be threaded all its length or partially threaded.

Alternatively, the second hole may have a metallic insert, or other material, where the screw is threaded.

In turn, the attachment means may be threaded along its entire length or partially threaded.

The length of the attaching means may protrude from the face of the housing opposite to the shunt device when the shunt device and the housing are attached. This protruding part of the attaching means may further attach an additional element to the current sensor housing. For instance, the battery pack as previously mentioned.

As previously stated, in an embodiment the housing further comprises an element, for instance a wall, in connection with the shunt device, directly contacting the shunt device or contacting it through an intermediate element, so as to prevent the rotation of the shunt device with respect to the housing when the attaching means is inserted through the first and the second hole for attaching the shunt device to the housing.

Thus, when the said attaching means, for instance, a screw, is being inserted to attach the shunt to the housing, if there is no element of the housing physically in connection with, for instance, a lateral portion of the perimeter of the shunt, the shunt tends to rotate with respect to the longitudinal axis of the attaching means. As the printed circuit board (PCB) is located in the housing by means of any fixation means, like a latch, there is a relative movement between shunt device and the printed circuit board (PCB). This relative movement may cause the joint between the shunt device and the printed circuit board (PCB) to break.

This problem is solved by the invention with an element of the housing being in connection with the shunt device to prevent it from turning.

The above current sensor arrangement prevents the tooling that makes the joint of the shunt device to the electrical conductor of the power supply system from touching the housing.

The claimed current sensor is solid since both, the shunt device, and the electrical conductor of the power supply system, are attached to the housing.

In addition, in an embodiment the operation of fixing the electrical conductors to the shunt device is improved, since it is performed against a solid element, the housing. In doing so, the purpose of the disclosed attaching means is to electrically connect the shunt device and the current sensor to the power supply system and to fix/attach the shunt device to the housing.

An additional advantage is that the claimed current sensor does not need a nut to join the electrical conductor and the shunt device as this fixation is performed directly against the housing or any other external element to the housing.

It is also an object of the invention a power supply system for a motor vehicle as defined in claim 12.

The electrical conductors may be busbars or cables. The electrical conductor may comprise an electrical terminal to be joined to the shunt device. The electrical terminal may be a tubular lug for cables.

According to the above claimed technical features, the current sensor object of the invention is an independent body from the power supply system. The current sensor is located and protected by its own housing, it is joint to the power supply system by the electrical conductors, said joint being performed within the perimeter of the housing of the current sensor. The claimed current sensor is thus portable in the sense that it does not comprise a battery pack, to the contrary, it is an independent element from the battery pack that can be located in any position of a power system.

It is also an object of the invention an assembly method of a current sensor for motor vehicles as defined in claim 13.

Preferably, the above-mentioned steps are carried out in the cited order.

In an embodiment, the assembly method of the current sensor into the power supply system comprises the steps of:
- Attaching the shunt device to the printed circuit board (PCB).
- Placing the printed circuit board (PCB) in the housing.
- Attaching the electrical conductors to the shunt device and to the housing.

Preferably, the above-mentioned steps are carried out in the cited order.

In a more preferred embodiment, the housing is provided with a metal insert into the second hole wherein the shunt device and electrical conductor are to be attached. The metallic insert may be threated.

### Description of the figures

To complete the description and to provide for a better understanding of the invention, a set of drawings is provided. Said drawings form an integral part of the description and illustrate preferred embodiments of the invention. The drawings comprise the following figures.
Figure 1 shows a perspective view of an embodiment of a shunt device and its electrical connections with a printed circuit board (PCB).
Figure 2 shows a perspective view of the embodiment of the shunt device of figure 1 connected to an embodiment of the printed circuit board (PCB).
Figure 3 shows a perspective view of an embodiment of a current sensor.
Figure 4 shows a plan view of the embodiment of the current sensor of figure 3.
Figure 5 shows a cross section of the embodiment of the current sensor of figure 4.
Figure 6 shows an exploded view of the embodiment of the current sensor of figure 3.

### Detailed description of the invention

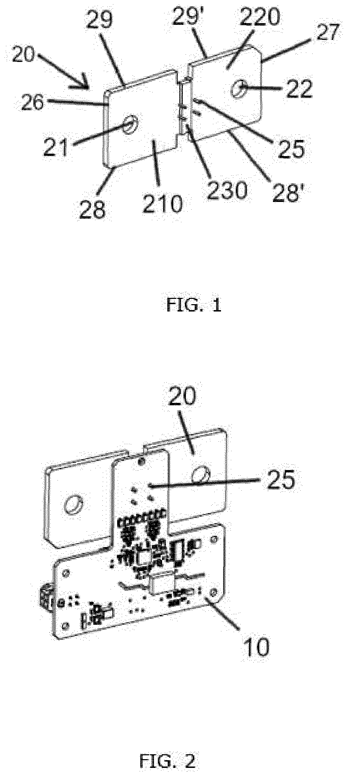

Figure 1 shows an embodiment of a shunt device (20) comprising electrical connection means (25), for instance pins, for being fixed to the printed circuit board (PCB) (10). Said fixation may be made by soldering.

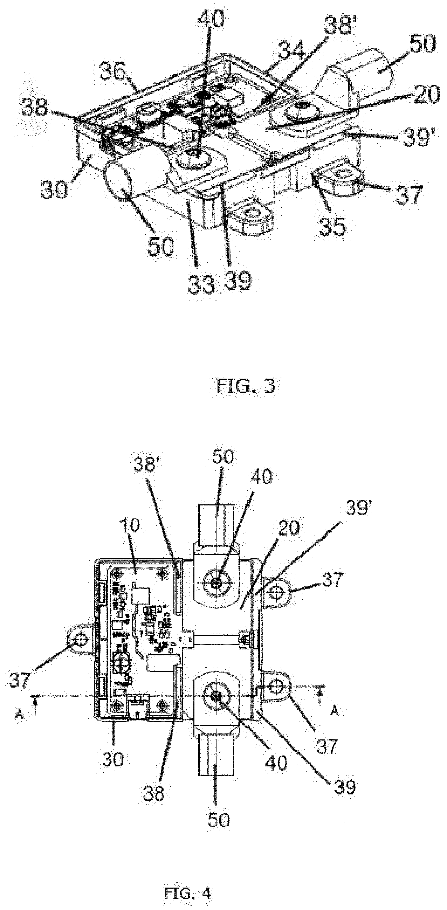

The shunt device (20) comprises two second portions (210, 220), specifically two end portions wherein the electrical conductors (50), shown in figure 3, are connected and a first portion (230), specifically a middle portion, wherein the resistive element is located.

Soldered pins may be located in the middle portion (230), or preferably in the two second portions (210, 220).

In the shown embodiment, each of the two second portions (210, 220) of the shunt device (20) comprises a first hole (21, 22).

The shunt device (20) preferably has a substantially rectangular shape, two long sides (29, 28) and two short sides (26, 27). In the shown embodiment, the middle portion (230) of the shunt device (20) splits the long sides (28, 29) into two portions (28, 28', 29, 29').

Figure 2 shows the aforementioned shunt device (20) and a printed circuit board (PCB) (10) in electrical connection through the mentioned soldered pins as connection means (25).

The shown shunt device (20) comprises a plurality of pins, in the shown embodiment it comprises four pins. The printed circuit board (PCB) (10) comprises a plurality of holes to allow the pins extending from the first portion (230) of the shunt device (20) towards the printed circuit board (PCB) (10) to pass through the holes. Preferably, soldered pins are located in the second portion (210, 220), for example, near the first portion (230). Near the first portion (230) may be understood within the meaning of the present invention as the pins are arranged closer to the first portion (230) than the two short sides (26, 27). Also, the pins may define a longitudinal axis that may be arranged between the first portion (230) and the first hole (21, 22) as seen in figure 1. A soldering is performed to join the pins to the printed circuit board (PCB) (10).

Figure 3 shows the above-mentioned assembly of the shunt device (20) and the printed circuit board (PCB) (10) of figure 2 fully located within the perimeter, contour, or limits of a first part (31) of the housing (30).

As previously stated, in use, the first holes (21, 22) of the shunt device (20) are located within the perimeter of the housing (30). Once the shunt device (20) is mounted in the housing (30), the first holes (21) of the shunt device (20) is aligned with the second holes (23) made in the housing (30). In this way, the attaching means (40), for example a screw, is inserted into the first hole (21) and at least partially into the second hole (23). The shunt device (20) is thus attached to the housing (30).

In an embodiment, the first hole (21) of the shunt device (20) is a through hole and without any thread. Preferably there is no contact between the attaching means (40) and the perimeter of the first hole (21). The second hole (23) in the housing (31) is a threaded hole so that, for instance, a screw is screwed in fixing the electrical conductor (50) and the shunt device (20) to the housing (30) of the current sensor.

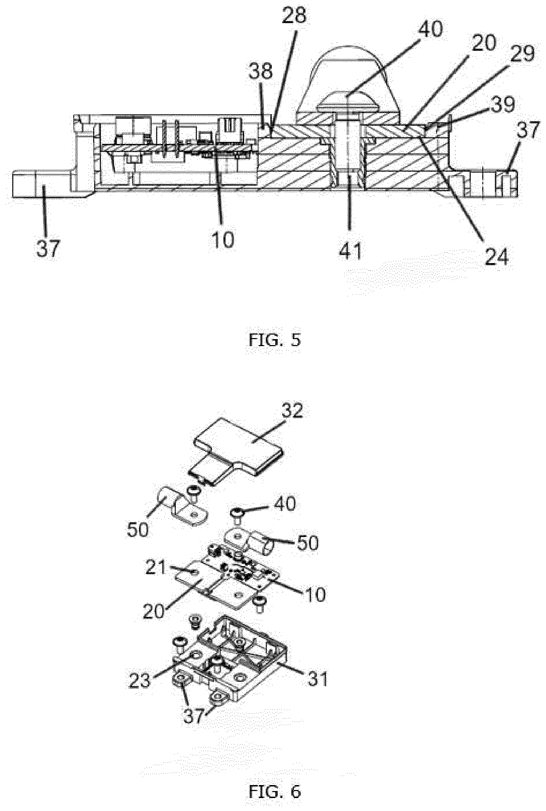

Preferably, the housing (30) comprises metallic inserts (41), see figure 5, in the second hole (23) with a thread. The metallic inserts (41) are over molded in, for instance, a plastic housing (30). This over molding process is done during the plastic injection, the metallic inserts (41) are introduced in the injection mould to be partially covered by the melted plastic.

The current sensor is configured for receiving the electrical conductors (50). In particular, the shunt device (20) is configured for receiving the electrical terminals of the electrical conductors (50). Said electrical conductors (50) may be any element which is electrically conductive, for example, a cable or a busbar. However, according to a preferred example, it is two tubular lugs or alternatively two bus bars. The tubular lugs and the bus bars are the terminals where the cables will be joined. Thus, the electrical power of for example 100A - 1000A comes from one bus-bar, passes through the shunt device (20) and goes through the other bus-bar, wherein the shunt device (20) which is in electrical connection with the printed circuit board (PCB) (10) comprising a current sensing device.

The attaching means (40) may comprise a head, a screw head, that presses downwardly the shunt device (20) against the housing (30) and additionally the electrical conductor (50) against the shunt device (20).

There may be direct contact between the screw head and the shunt device (20), or alternatively, according to a preferred embodiment, a portion of the electrical conductors (50) is located between the attaching means (40), for instance the screw head, and the shunt device (20). That is, a portion of the electrical conductors (50) is pressed from above by the attaching means (40) and from below by a surface of the shunt device (20). Since there is direct contact between the attaching means (40), the electrical conductors (50) and the shunt device (20), the electrical connection between the electrical conductors (50) and the shunt device (20) is ensured.

As previously mentioned, the shunt device (20) tends to move, particularly, rotate, with respect to the longitudinal axis of the attaching means (40) and this movement may break or damage the electrical joint between the printed circuit board (PCB) (10) and the shunt device (20).

The above problem is solved in an embodiment by providing a wall (39, 39', 38, 38') in the housing (30) that contacts the perimeter of the shunt device (20). In the shown embodiment, said walls (39, 39', 38, 38') are located in the first part (31) of the housing (30). In an alternative embodiment, the walls (39, 39', 38, 38') may be located in the second part (32) or cover of the housing (30) and once the cover is in place blocks the rotation of the shunt device (20).

The mentioned walls (39, 39', 38, 38') contact a lateral portion (29, 29', 28, 28') of the perimeter of the shunt device (20). Thus, this wall (39, 39', 38, 38') acts as a stopper, i.e., it restricts the movement of the shunt device (20) in the rotation.

Figure 5 shows a cross-section of the current sensor. Walls (38, 39) of the housing (30) preventing the rotation of the shunt device (20) are shown. One of the walls (38) contacts a side portion (28) of the shunt device (20), and the other wall (39) contacts the other side portion (29) of the shunt device (20).

When the attaching means (40) is being screwed in, any of the following four combinations restrict the rotational movement:
(i) 39 + (38 o 38');
(ii) 39' + (38 o 38');
(iii) 38 + (39 o 39');
(iv) 38' + (39 o 39').

Preferably, the housing (30) has a rectangular shape in a plan view. As shown in figure 6, the housing (30) comprises a first part (31) and a second part (32) that is a lid or cover of the first part (31) of the current sensor. The housing (30) comprises four sides (33, 34, 35, 36). Two opposite sides (33, 34) comprise a recess (24) to facilitate the assembly of the shunt device (20).

In a preferred embodiment, the housing (30) is made of plastic.

The housing (30) further comprises additional attaching means (37) for fixing the current sensor to the vehicle. The additional attaching means (37) form an integral part with the housing (30) or are joined to the housing (30). As can be seen in figure 4, in the shown embodiment the additional attaching means (37) are three abutments of the housing (30) with a through hole located in two of the sides (35, 36) of the housing (30).

Figure 5 shows that the printed circuit board (PCB) (10) is located in a position below the position of the shunt device (20). Therefore, a vertical gap may exist between the location of the printed circuit board (PCB) (10) and the location of the shunt device (20).

The printed circuit board (PCB) (10) may have several geometries. The attaching means (40) is responsible for joining the shunt device (20) to the housing (30) and thus the printed circuit board (PCB) (10) should not be located in the area were the attaching means (40) are located. Alternatively, the printed circuit board (PCB) (10) may have holes, for instance, for positioning it into the housing (30). Although it is not advisable to locate electronic elements near or below the shunt device (20), especially at high voltages.

The second part (32) or cover of the housing (30) does not cover the holes (21, 22) of the shunt device (20) so that the attaching means (40) are not covered by the second part (32) of the housing (30).

The claimed current sensor is portable, i.e., it is an independent body from the battery pack. With the above configuration of the second part (32), the electrical connector (50) of the power supply may be connected to the shunt device (20) with the second part (32) on, so that the printed circuit board (PCB) (10) and the shunt device (20) are protected by this second part (32).

More specifically, figure 6 discloses a second part (32) having a T-shape which allows the insertion of the attaching means (40) with the second part (32) located onto the first part (31). As previously stated, the second part (32) may comprise the mentioned anti-rotation walls (39, 39', 38, 38').

In the shown embodiment the printed circuit board (PCB) (10) also has a T-shape. Therefore, the printed circuit board (PCB) (10) portion located under the shunt device (20) is narrower than in other configurations of the prior art which leads to an increased space in the current sensor for the placement of electronic components. In the shown embodiment the housing (31) has a T-shaped area for positioning the printed circuit board (PCB) (10).

According to an embodiment not shown, the attaching means may be adapted for engaging the battery pack or another element located out of the housing (30). The attaching means may go through the first (21, 22) and the second holes (23) so as to attach the shunt device (20) to the housing (30). This is, the attaching means (40) is a fastener such as a screw having a length larger than the attaching means shown in figures 3 to 6, which allows said attaching means (40) to further engage (i.e., screw) the battery pack. Therefore, an end opposite the head of the screw may be located in the first part (31) of the housing (30) (shown embodiment), or alternatively, in the battery pack (not shown). Other locations of said end are of course possible. The technical advantage of this embodiment is that with only one attaching means the shunt device (20) and the housing (30) are attached and the current sensor is further attach to the battery pack.

In an embodiment, at least a portion of the battery pack may be arranged underneath the current sensor. This is, at least a portion of the housing (30) may be arranged between the shunt device (20) and a portion of the battery pack.

The assembly method of the shown embodiment of the current sensor would be as follows:
- providing a housing (30),
- locating at least a portion of a shunt device (20) into a printed circuit board (PCB) (10), the shunt device (20) comprising a first portion (230) comprising a resistive element having a pre-set resistance and a second portion (210, 220) configured to be connected to an electrical conductor (50),

- locating at least a portion of the printed circuit board (PCB) (10) into the housing (30),
- providing attaching means (40),
- attaching the shunt device (20) to the housing (30) by the attaching means (40) going through a first hole (21) located in the second portion (210, 220) of the shunt device (20) and through a second hole (23) of the housing (30).

In an embodiment, the method comprises the further step of connecting the shunt device (20) and the printed circuit board (PCB) (10) to each other through the electrical connection means (25).

In an embodiment, the method comprises the further step of introducing a screw into the additional attaching means (37) making it possible to fix the current sensor to a part of the battery electrical power supply system.

In an embodiment, the method comprises the further step of attaching the current sensor by introducing the attaching means (40) into a part of the battery electrical power supply system so as to fix the current sensor to said battery electrical power supply system. In particular, the battery electrical power supply system is the battery pack.

## Claims

1. A current sensor for motor vehicles comprising:
- a printed circuit board (PCB) (10);
- a shunt device (20) comprising a first portion (230) comprising a resistive element having a pre-set resistance and a two second portions (210, 220) each second portion (210, 220) configured to be connected to an electrical conductor (50), each second portion (210, 220) comprising a first hole (21, 22), and
- a housing (30) enclosing at least a portion of the printed circuit board (10), PCB;
the housing (30) comprises two second holes (23) and the current sensor further comprises two attaching means (40), each attaching means (40) going through one first hole (21) and one second hole (23) so as to attach the shunt device (20) to the housing (30), the attaching means (40) being further configured to attach each electrical conductor (50) to each first hole (21, 22) of the shunt device (20) such that a provided power supply is configured to circulate to the shunt device (20) through the electrical conductors (50), wherein the current sensor is **characterised in that** the housing (30) encloses at least a portion of the shunt device (20).

2. A current sensor for motor vehicles, according to claim 1, wherein the housing (30) further comprises an element (39, 39', 38, 38') in connection with the shunt device (20) so as to prevent the rotation of the shunt device (20) with respect to the housing (30) when the attaching means (40) is being inserted through the first and the second hole (21, 23) for attaching the shunt device (20) to the housing (30).

3. A current sensor for motor vehicles, according to any preceding claim, wherein the housing (30) comprises additional attaching means (37) for fixing the current sensor to a power supply system of the motor vehicle.

4. A current sensor for motor vehicles, according to any preceding claim, wherein the housing (30) comprises a first part (31) and a second part (32) acting as a cover of the first part (31).

5. A current sensor for motor vehicles, according to claim 4, wherein the shunt device (20) and the PCB (10) are located within the perimeter of the first part (31) of the housing (30).

6. A current sensor for motor vehicles, according to claim 4 or 5, wherein the second part (32) of the housing (30) does not cover the hole (21, 22) of the shunt device (20) so that the attaching means (40) between the shunt device (20) and the housing (30) is not covered by the second part (32) of the housing (30).

7. A current sensor for motor vehicles, according to any preceding claim 2 to 6, wherein the element of the housing (30) for preventing the rotation of the shunt device (20) comprises a wall (39, 39', 38, 38') in contact with the perimeter (29, 29', 28, 28') of the shunt device (20).

8. A current sensor for motor vehicles, according to any preceding claim, wherein the shunt device (20) further comprises electrical connection means (25) in electrical contact with the PCB (10), the electrical connection means (25) being located in the second portion (210, 220) of the shunt device (20).

9. A current sensor for motor vehicles, according to any preceding claim, wherein the housing (30) is made of plastic.

10. A current sensor for motor vehicles, according to any preceding claim, wherein the housing (30) comprises in the second hole (23) a metallic insert (41) comprising a thread.

11. A current sensor for motor vehicles, according to any preceding claim, wherein the attaching means (40) is a screw.

12. A power supply system for a motor vehicle comprising:
- the current sensor of any preceding claim.

13. Assembly method of a current sensor for motor vehicles, comprising the following steps:
- providing a housing (30),
- locating at least a portion of a shunt device (20) into a printed circuit board (10), PCB, the shunt device (20) comprising a first portion (230) comprising a resistive element having a pre-set resistance and two second portions (210, 220) configured to be connected to an electrical conductor (50), each second portion (210, 220) comprising a first hole (21, 22),
- locating at least a portion of the PCB (10) into the housing (30), the housing (30) comprising two second holes (23),
- providing two attaching means (40),
- attaching the shunt device (20) to the housing (30) by the two attaching means (40), each attaching means (40) going through one first hole (21) located in the second portion (210, 220) of the shunt device (20) and through one second hole (23) of the housing (30) the attaching means (40) being further configured to attach each electrical conductor (50) to each first hole (21, 22) of the shunt device (20) such that a provided power supply is configured to circulate to the shunt device (20) through the electrical conductors (50), wherein the method is **characterised by** locating at least a portion of the shunt device (20) into the housing (30).

## Patentansprüche

1. Stromsensor für Kraftfahrzeuge, umfassend:
- eine Leiterplatte (PCB) (10);
- eine Nebenschlussvorrichtung (20), die einen ersten Abschnitt (230), der ein Widerstandselement mit einem voreingestellten Widerstand umfasst, und zwei zweite Abschnitte (210, 220) umfasst, wobei jeder zweite Abschnitt (210, 220) konfiguriert ist, um mit einem elektrischen Leiter (50) verbunden zu werden, wobei jeder zweite Abschnitt (210, 220) ein erstes Loch (21, 22) umfasst, und
- ein Gehäuse (30), das mindestens einen Teil der Leiterplatte (10), PCB, umschließt;
das Gehäuse (30) zwei zweite Löcher (23) umfasst und der Stromsensor ferner zwei Befestigungsmittel (40) umfasst, wobei jedes Befestigungsmittel (40) durch ein erstes Loch (21) und ein zweites Loch (23) geht, um die Nebenschlussvorrichtung (20) an dem Gehäuse (30) zu befestigen, wobei das Befestigungsmittel (40) ferner konfiguriert ist, um jeden elektrischen Leiter (50) an jedem ersten Loch (21, 22) der Nebenschlussvorrichtung (20) zu befestigen, so dass eine bereitgestellte Stromversorgung konfiguriert ist, durch die elektrischen Leiter (50) zu der Nebenschlussvorrichtung (20) zu zirkulieren, wobei der Stromsensor **dadurch gekennzeichnet ist, dass** das Gehäuse (30) mindestens einen Abschnitt der Nebenschlussvorrichtung (20) umschließt.

2. Stromsensor für Kraftfahrzeuge nach Anspruch 1, wobei das Gehäuse (30) ferner ein Element (39, 39', 38, 38') in Verbindung mit der Nebenschlussvorrichtung (20) umfasst, um die Drehung der Nebenschlussvorrichtung (20) in Bezug auf das Gehäuse (30) zu verhindern, wenn das Befestigungsmittel (40) durch das erste und das zweite Loch (21, 23) eingeführt wird, um die Nebenschlussvorrichtung (20) an dem Gehäuse (30) zu befestigen.

3. Stromsensor für Kraftfahrzeuge nach einem der vorhergehenden Ansprüche, wobei das Gehäuse (30) zusätzliche Befestigungsmittel (37) zum Befestigen des Stromsensors an einem Stromversorgungssystem des Kraftfahrzeugs umfasst.

4. Stromsensor für Kraftfahrzeuge nach einem der vorhergehenden Ansprüche, wobei das Gehäuse (30) einen ersten Teil (31) und einen zweiten Teil (32) umfasst, der als Abdeckung des ersten Teils (31) wirkt.

5. Stromsensor für Kraftfahrzeuge nach Anspruch 4, wobei die Nebenschlussvorrichtung (20) und die Leiterplatte (10) innerhalb des Umfangs des ersten Teils (31) des Gehäuses (30) angeordnet sind.

6. Stromsensor für Kraftfahrzeuge nach Anspruch 4 oder 5, wobei der zweite Teil (32) des Gehäuses (30) das Loch (21, 22) der Nebenschlussvorrichtung (20) nicht abdeckt, so dass das Befestigungsmittel (40) zwischen der Nebenschlussvorrichtung (20) und dem Gehäuse (30) nicht durch den zweiten Teil (32) des Gehäuses (30) abgedeckt ist.

7. Stromsensor für Kraftfahrzeuge nach einem der vorhergehenden Ansprüche 2 bis 6, wobei das Element des Gehäuses (30) zum Verhindern der Drehung der Nebenschlussvorrichtung (20) eine Wand (39, 39', 38, 38') in Kontakt mit dem Umfang (29, 29', 28, 28') der Nebenschlussvorrichtung (20) umfasst.

8. Stromsensor für Kraftfahrzeuge nach einem der vorhergehenden Ansprüche, wobei die Nebenschlussvorrichtung (20) ferner ein elektrisches Verbindungsmittel (25) in elektrischem Kontakt mit dem 2. umfasst. I¹ Leiterplatte (10), wobei sich die elektrischen Verbindungsmittel (25) im zweiten Abschnitt (210, 220) der Nebenschlussvorrichtung (20) befinden.

9. Stromsensor für Kraftfahrzeuge nach einem der vorhergehenden Ansprüche, wobei das Gehäuse (30) aus Kunststoff hergestellt ist.

10. Stromsensor für Kraftfahrzeuge nach einem der vorhergehenden Ansprüche, wobei das Gehäuse (30) in dem zweiten Loch (23) einen metallischen Einsatz (41) mit einem Gewinde aufweist.

11. Stromsensor für Kraftfahrzeuge nach einem der vorhergehenden Ansprüche, wobei das Befestigungsmittel (40) eine Schraube ist.

12. Stromversorgungssystem für ein Kraftfahrzeug, umfassend:
- den Stromsensor nach einem der vorhergehenden Ansprüche.

13. Montageverfahren eines Stromsensors für Kraftfahrzeuge, umfassend die folgenden Schritte:
- Bereitstellen eines Gehäuses (30),
- Anordnen mindestens eines Abschnitts einer Nebenschlussvorrichtung (20) in einer Leiterplatte (10), PCB (10), wobei die Nebenschlussvorrichtung (20) einen ersten Abschnitt (230) umfasst, der ein Widerstandselement mit einem voreingestellten Widerstand aufweist, und zwei zweite Abschnitte (210, 220), die konfiguriert sind, um mit einem elektrischen Leiter (50) verbunden zu werden, wobei jeder zweite Abschnitt (210, 220) ein erstes Loch (21, 22) umfasst,
- Anordnen mindestens eines Teils der Leiterplatte (10) in dem Gehäuse (30), wobei das Gehäuse (30) zwei zweite Löcher (23) umfasst,
- Bereitstellen von zwei Befestigungsmitteln (40),
- Befestigen der Nebenschlussvorrichtung (20) an dem Gehäuse (30) durch die zwei Befestigungsmittel (40), wobei jedes Befestigungsmittel (40) durch ein erstes Loch (21), das sich in dem zweiten Abschnitt (210, 220) der Nebenschlussvorrichtung (20) befindet, und durch ein zweites Loch (23) des Gehäuses (30) geht, wobei das Befestigungsmittel (40) ferner dazu konfiguriert ist, jeden elektrischen Leiter (50) an jedem ersten Loch (21, 22) der Nebenschlussvorrichtung (20) zu befestigen, so dass eine bereitgestellte Stromversorgung dazu konfiguriert ist, durch die elektrischen Leiter (50) zu der Nebenschlussvorrichtung (20) zu zirkulieren, wobei das Verfahren **dadurch gekennzeichnet ist, dass** mindestens ein Abschnitt der Nebenschlussvorrichtung (20) in dem Gehäuse (30) angeordnet wird.

## Revendications

1. Capteur de courant pour véhicules à moteur comprenant :
- une carte de circuit imprimé (PCB) (10) ;
- un dispositif de dérivation (20) comprenant une première partie (230) comprenant un élément résistif ayant une résistance prédéfinie et deux secondes parties (210, 220), chaque seconde partie (210, 220) étant configurée pour être connectée à un conducteur électrique (50), chaque seconde partie (210, 220) comprenant un premier trou (21, 22), et
- un boîtier (30) renfermant au moins une partie de la carte de circuit imprimé (PCB) (10) ;
le boîtier (30) comprend deux seconds trous (23) et le capteur de courant comprend en outre deux moyens de fixation (40), chaque moyen de fixation (40) passant à travers un premier trou (21) et un second trou (23) de manière à fixer le dispositif de dérivation (20) au boîtier (30), les moyens de fixation (40) étant en outre configurés pour fixer chaque conducteur électrique (50) à chaque premier trou (21, 22) du dispositif de dérivation (20) de sorte qu'une alimentation électrique fournie est configurée pour circuler vers le dispositif de dérivation (20) à travers les conducteurs électriques (50), dans lequel le capteur de courant est **caractérisé en ce que** le boîtier (30) renferme au moins une partie du dispositif de dérivation (20).

2. Capteur de courant pour véhicules à moteur selon la revendication 1, dans lequel le boîtier (30) comprend en outre un élément (39, 39', 38, 38') en relation avec le dispositif de dérivation (20) de manière à empêcher la rotation du dispositif de dérivation (20) par rapport au boîtier (30) lorsque les moyens de fixation (40) sont insérés à travers le premier et le second trou (21, 23) pour fixer le dispositif de dérivation (20) au boîtier (30).

3. Capteur de courant pour véhicules à moteur selon l'une quelconque des revendications précédentes, dans lequel le boîtier (30) comprend des moyens de fixation supplémentaires (37) pour fixer le capteur de courant à un système d'alimentation électrique du véhicule à moteur.

4. Capteur de courant pour véhicules à moteur selon l'une quelconque des revendications précédentes, dans lequel le boîtier (30) comprend une première partie (31) et une seconde partie (32) faisant office de couvercle de la première partie (31).

5. Capteur de courant pour véhicules à moteur selon la revendication 4, dans lequel le dispositif de dérivation (20) et la PCB (̵10) sont situés à l'intérieur du périmètre de la première partie (31) du boîtier (30).

6. Capteur de courant pour véhicules à moteur selon la revendication 4 ou 5, dans lequel la seconde partie (32) du boîtier (30) ne recouvre pas le trou (21, 22) du dispositif de dérivation (20) de sorte que le moyen de fixation (40) entre le dispositif de dérivation (20) et le boîtier (30) n'est pas recouvert par la seconde partie (32) du boîtier (30).

7. Capteur de courant pour véhicules à moteur selon l'une quelconque des revendications précédentes 2 à 6, dans lequel l'élément du boîtier (30) destiné à empêcher la rotation du dispositif de dérivation (20) comprend une paroi (39, 39', 38, 38') en contact avec le périmètre (29, 29', 28, 28') du dispositif de dérivation (20).

8. Capteur de courant pour véhicules à moteur selon l'une quelconque des revendications précédentes, dans lequel le dispositif de dérivation (20) comprend en outre des moyens de connexion électrique (25) en contact électrique avec la I¹ PCB (10), les moyens de connexion électrique (25) étant situés dans la seconde partie (210, 220) du dispositif de dérivation (20).

9. Capteur de courant pour véhicules à moteur selon l'une quelconque des revendications précédentes, dans lequel le boîtier (30) est en plastique.

10. Capteur de courant pour véhicules à moteur selon l'une quelconque des revendications précédentes, dans lequel le boîtier (30) comprend dans le second trou (23) un insert métallique (41) comprenant un filetage.

11. Capteur de courant pour véhicules à moteur selon l'une quelconque des revendications précédentes, dans lequel le moyen de fixation (40) est une vis.

12. Système d'alimentation électrique pour véhicules à moteur comprenant :
- le capteur de courant de l'une quelconque des revendications précédentes.

13. Procédé d'assemblage d'un capteur de courant pour véhicules à moteur, comprenant les étapes suivantes :
- fournir un boîtier (30),
- placer au moins une partie d'un dispositif de dérivation (20) dans une carte de circuit imprimé (PCB) (10), le dispositif de dérivation (20) comprenant une première partie (230) comprenant un élément résistif ayant une résistance prédéfinie et deux secondes parties (210, 220) configurées pour être connectées à un conducteur électrique (50), chaque seconde partie (210, 220) comprenant un premier trou (21, 22),
- placer au moins une partie de la PCB (10) dans le boîtier (30), le boîtier (30) comprenant deux seconds trous (23),
- prévoir deux moyens de fixation (40),
- fixer le dispositif de dérivation (20) au boîtier (30) par les deux moyens de fixation (40), chaque moyen de fixation (40) passant à travers un premier trou (21) situé dans la seconde partie (210, 220) du dispositif de dérivation (20) et à travers un second trou (23) du boîtier (30), les moyens de fixation (40) étant en outre configurés pour fixer chaque conducteur électrique (50) à chaque premier trou (21, 22) du dispositif de dérivation (20) de telle sorte qu'une alimentation électrique fournie est configurée pour circuler vers le dispositif de dérivation (20) à travers les conducteurs électriques (50), dans lequel le procédé est **caractérisé par** le placement d'au moins une partie du dispositif de dérivation (20) dans le boîtier (30).
